# EUROPEAN PATENT SPECIFICATION

(11) **EP 4 036 969 B1**
(45) Date of publication and mention of the grant of the patent: **28.01.2026**
(21) Application number: 19948973.3
(22) Date of filing: 16.10.2019
(51) Int. Cl.: H01L 23/538, H01L 23/498, H01L 23/66, H01L 25/065

(54) **CHIP AND INTEGRATED CHIP**
CHIP UND INTEGRIERTER CHIP
PUCE ET PUCE INTÉGRÉE

(43) Date of publication of application: 03.08.2022
(73) Proprietor: Huawei Technologies Co., Ltd., Longgang District Shenzhen, Guangdong 518129 (CN)
(72) Inventor: HUANG, Weichao, Shenzhen, Guangdong 518129 (CN); LI, Tao, Shenzhen, Guangdong 518129 (CN)
(74) Representative: Thun, Clemens
(86) International application number: PCT/CN2019/111430
(87) International publication number: WO 2021/072670

(56) References cited:
- CN-A- 101 599 439
- CN-A- 103 295 996
- CN-A- 103 413 796
- CN-A- 105 742 280
- US-A- 5 059 899
- US-A1- 2013 313 723
- US-A1- 2014 177 626
- US-A1- 2018 157 782
- US-A1- 2019 319 626
- US-B1- 9 543 249

## Description

### TECHNICAL FIELD

This application relates to the field of integrated circuit technologies, and in particular, to a chip and an integrated chip.

### BACKGROUND

With development of semiconductor technologies, electronic devices tend to be light, thin, short, and small, and more performance and features are integrated in increasingly smaller space. Therefore, a chip packaging technology also becomes increasingly important in an electronic device industry chain.

Generally, a wafer is cut into a plurality of dies. As a chip becomes larger, a quantity of dies integrated in a single package continuously increases, and interconnection and communication need to be performed among the plurality of dies integrated in the single package.

In the conventional technology, the plurality of dies integrated in the single package are interconnected through routing in an area enclosed by a peripheral boundary of the plurality of dies. Consequently, routing in the area is complex, there is much data signal interference, and a delay of data signal transmission in the area is large.

In the field of high-performance computing, some pairs of dies (to be specific, one pair of dies includes two dies) in the plurality of dies integrated in the single package are sensitive to the delay of data signal transmission. In other words, the delay of data signal transmission is required to be low. It is clear that the foregoing solution in the conventional technology cannot implement a low data signal transmission delay.
The document US 2018/0157782 Al shows an automated place-and-route method for HBM-based IC devices. Especially, an interconnection of several dies on a carrier, using a bounding box is shown.
The document US 9,543,429 B1 shows a die packaging structure with lateral communication circuitry. Also here, a connection of several dies in a packaging using bounding boxes is shown.

### SUMMARY

The present invention is defined by the independent claims. Further advantageous developments are shown by the dependent claims.

This application provides a chip and an integrated chip, to reduce a delay of data signal transmission between a pair of dies and improve data transmission efficiency. To achieve the foregoing objectives, embodiments of this application provide the following technical solutions.

According to a first aspect, this application provides a chip, including:
an interconnect layer, and a plurality of dies disposed on the interconnect layer. The plurality of dies include a first die and a second die, the first die and the second die are interconnected through routing in an edge area, the edge area is an area outside a bounding box on the interconnect layer, and the bounding box is a peripheral boundary of the plurality of dies on the interconnect layer.

Because there is no routing interference or little signal interference in the edge area, the first die and the second die are interconnected through routing in the edge area. In this way, a delay of data signal transmission between a pair of dies can be reduced, and data transmission efficiency can be improved.

The first die is not adjacent to the second die. In other words, a pair of non-adjacent dies is interconnected through routing in the edge area.

The plurality of dies further include a third die, the first die is adjacent to the third die, the first die and the third die are interconnected through routing in a bounding box area on the interconnect layer, and the bounding box area is an area enclosed by the bounding box on the interconnect layer. In other words, a pair of adjacent dies is interconnected through routing in the bounding box area.

The second die is adjacent to the third die, and the second die and the third die are interconnected through routing in the bounding box area on the interconnect layer.

In a possible implementation, the bounding box is a die top bounding box, and the die top bounding box indicates a boundary formed by peripheral dies in the plurality of dies.

In a possible implementation, the bounding box is a die angle bounding box, and the die angle bounding box indicates a boundary formed by vertex connecting lines of the plurality of dies.

In a possible implementation, the bounding box is a die gap bounding box, and the die gap bounding box indicates a boundary that covers gap areas among the plurality of dies and areas of the plurality of dies.

In a possible implementation, the bounding box is determined based on sizes, shapes, and arrangements of the plurality of dies.

In a possible implementation, a packaging manner of the chip is fan-out packaging, and the interconnect layer is a redistribution layer.

In a possible implementation, a packaging manner of the chip is CoWoS packaging, and the interconnect layer is an interposer.

In a possible implementation, a packaging manner of the chip is multi-chip module packaging, and the interconnect layer is a substrate.

In a possible implementation, each of the plurality of dies includes uBumps, and the plurality of dies are interconnected through routing by using the uBumps.

According to a second aspect, this application provides an integrated chip, including a first chip and a second chip. The first chip is the chip according to any one of the first aspect or the implementations of the first aspect, and the first chip and the second chip are packaged together.

### BRIEF DESCRIPTION OF DRAWINGS

FIG. 1a provides a schematic diagram of communication among a plurality of dies in a single package by crossing an intermediate die;
FIG. 1b provides a cross-sectional view corresponding to FIG. 1a;
FIG. 2a is a schematic diagram of a die top bounding box of three dies according to an embodiment of this application;
FIG. 2b is a schematic diagram of a die angle bounding box of three dies according to an embodiment of this application;
FIG. 2c is a schematic diagram of a die gap bounding box of three dies according to an embodiment of this application;
FIG. 3a is a schematic diagram of a bounding box of three dies according to another embodiment of this application;
FIG. 3b is a schematic diagram of a bounding box of five dies according to an embodiment of this application;
FIG. 4a is a schematic diagram of routing on a die top bounding box provided in FIG. 2a according to an embodiment of this application;
FIG. 4b is a schematic diagram of routing on a die angle bounding box provided in FIG. 2b according to an embodiment of this application;
FIG. 4c is a schematic diagram of routing on a die gap bounding box provided in FIG. 2c according to an embodiment of this application;
FIG. 5 is a schematic cross-sectional view corresponding to FIG. 4a, FIG. 4b, and FIG. 4c according to an embodiment of this application;
FIG. 6a is a schematic diagram of routing of nine dies based on a die top bounding box according to an embodiment of this application;
FIG. 6b is a schematic diagram of routing of nine dies based on a die angle bounding box according to an embodiment of this application;
FIG. 6c is a schematic diagram of routing of nine dies based on a die gap bounding box according to an embodiment of this application;
FIG. 7a is a schematic cross-sectional view corresponding to FIG. 6a, FIG. 6b, and FIG. 6c according to an embodiment of this application;
FIG. 7b is a schematic cross-sectional view corresponding to FIG. 6a, FIG. 6b, and FIG. 6c according to another embodiment of this application;
FIG. 8a is a schematic diagram of routing of three dies based on fan-out packaging and a die top bounding box according to an embodiment of this application;
FIG. 8b is a cross-sectional view corresponding to FIG. 8a according to an embodiment of this application;
FIG. 9a is a schematic diagram of routing of three dies based on CoWoS packaging and a die top bounding box according to an embodiment of this application;
FIG. 9b is a cross-sectional view corresponding to FIG. 9a according to an embodiment of this application;
FIG. 10a is a schematic diagram of routing of three dies based on MCM packaging and a die top bounding box according to an embodiment of this application; and
FIG. 10b is a cross-sectional view corresponding to FIG. 10a according to an embodiment of this application.

### DESCRIPTION OF EMBODIMENTS

A plurality of dies in a single package are interconnected through routing in an area (a bounding box area) enclosed by a peripheral boundary of the plurality of dies. Generally, adjacent dies in the plurality of dies are interconnected through direct routing in the area, and non-adjacent dies are interconnected by crossing an intermediate die (the intermediate die is adjacent to both of the two non-adjacent dies). In other words, a die on one side transmits a data signal to the intermediate die, and then the intermediate die transmits the data signal to a die on the other side. Therefore, the intermediate die performs a transmission transit function, and this manner of interconnection by crossing the intermediate die may also be referred to as indirect routing for interconnection.

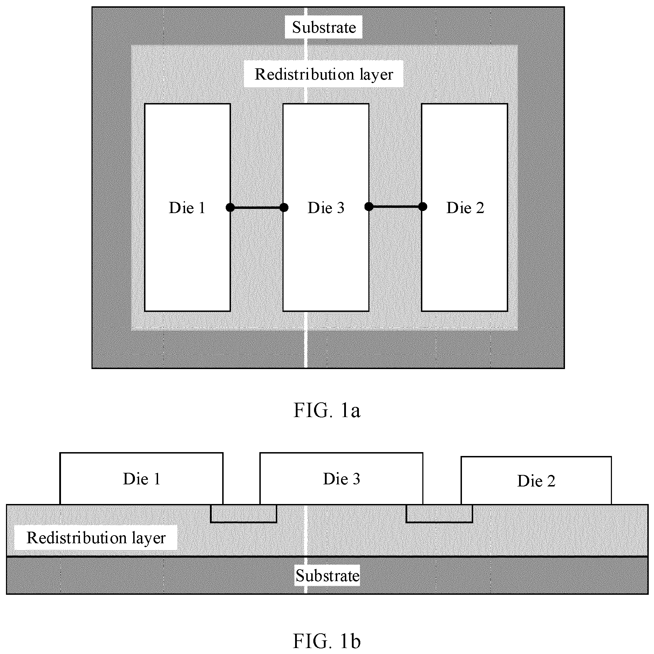

FIG. la provides a schematic diagram of interconnection and communication among a plurality of dies integrated in a single package by crossing an intermediate die. In addition, in FIG. 1a, a fan-out packaging (Fan-out Packaging, FOP) in a 2.5D packaging technology is used as an example, and three dies, namely, a die 1, a die 2, and a die 3, are integrated in a single package. A redistribution layer (Redistribution Layer, RDL) and a substrate (substrate) are below the three dies in sequence. The die 1 is not adjacent to the die 2, and the die 3, as an intermediate die of the die 1 and the die 2, is adjacent to the die 1 and the die 2 respectively. Because the die 3 is adjacent to the die 1 and the die 2 respectively, the die 3 is interconnected to the die 1 and the die 2 through direct routing. Because the die 1 is not adjacent to die 2, when a data signal is transmitted between the die 1 and the die 2, the data signal is first transmitted to the die 3, and then the die 3 transmits the data signal. For example, the die 1 transmits the data signal to the die 3, and then the die 3 transmits the data signal to the die 2. In this way, it is implemented that the die 1 transmits the data signal to the die 2. In other words, the die 1 and the die 3 are interconnected by crossing the die 2. It should be noted that FIG. la is a top view, and FIG. 1b is a cross-sectional view corresponding to FIG. 1a. A hierarchical relationship of the substrate, the redistribution layer, and the dies can be more clearly seen from FIG. 1b.

It is clear that because the die 1 and the die 2 that are not adjacent are interconnected by crossing the die 3, in other words, the die 1 and the die 2 are interconnected through indirect routing, a delay of transmission between the die 1 and the die 2 is affected, and the delay of transmission is high. Because the die 3 and the die 1 (or the die 2) that are adjacent are directly routed, generally, a delay of transmission between the die 3 and the die 1 (or the die 2) is low. However, in some specific scenarios, for example, in a scenario in which direct routing is interfered with by a large quantity of other signals, a problem of a high delay of transmission may also exist.

To resolve a problem of a delay of data signal transmission between a pair of dies in a plurality of dies integrated in a single package, this application provides a solution in which routing is performed in an edge (edge) area, to implement interconnection and communication, reduce the delay of data signal transmission between the pair of dies, and improve data transmission efficiency.

Before specific implementations of this application are described, related terms in this application are first described.

Die (Die): The die is also referred to as a bare chip, a bare die, a wafer, or the like, and is a chip that is cut from a wafer and that is not packaged. Each die is a chip that has an independent function and that is not packaged. The die cannot be directly used in an actual circuit. The die is easily affected by an external environment temperature, an impurity, and physical force, and is easily damaged. Therefore, the die needs to be sealed in confined space, and a corresponding pin needs to be led out. In this way, the die can be used as a basic component.

Interconnect layer: The interconnect layer is a layer disposed below a plurality of dies integrated in a single package. In other words, the plurality of dies are disposed on the interconnect layer. The plurality of dies are generally routed on the interconnect layer to implement a communicative connection. In a specific implementation, the interconnect layer may be a redistribution layer (redistribution layer, RDL), an interposer (interposer), a substrate (substrate), or an embedded multi-die interconnect bridge (Embedded Multi-Die Interconnect Bridge, EMIB). The interconnect layer may include a plurality of dielectric layers, conductive layers sandwiched among the dielectric layers, and the like.

Bounding box (Bounding box): Because a plurality of dies may be integrated in a single package, a peripheral boundary of the plurality of dies is referred to as a bounding box. Because the dies are generally disposed on the interconnect layer, the bounding box in this application is a peripheral boundary of the plurality of dies on the interconnect layer.

Bounding box area: The bounding box area is an area enclosed by a bounding box on an interconnect layer.

Edge (edge) area: The edge area is an area outside a bounding box area on an interconnect layer.

Adjacent dies: A plurality of dies are integrated in a single package, and the plurality of dies can form a bounding box area. If two dies in the plurality of dies are interconnected through routing in the bounding box area without crossing another die, in other words, the two dies are interconnected through direct routing, the two dies are adjacent dies.

Non-adjacent dies: Dies in a pair of dies that do not belong to the foregoing adjacent dies are non-adjacent dies.

The following points need to be noted:
1. In the following descriptions of embodiments of this application, a "first die" is described in some parts, and a "die 1" is described in some parts. Actually, the "first die" is the "die 1". Similarly, a "second die" is a "die 2", and a "third die" is a "die 3". By analogy, an "N^{th} die" is a "die N", where N is a positive integer. In the accompanying drawings of this application, for ease of description, the "die 1", the "die 2" and the "die N" are uniformly used. "A plurality of" in embodiments of this application means two or more than two.

In the descriptions of embodiments of this application, terms such as "first" and "second" are only used for distinction and description, but cannot be understood as indication or implication of relative importance, and cannot be understood as an indication or implication of a sequence.

To make objectives, technical solutions, and advantages of this application more clearly, the following further describes this application in detail with reference to the accompanying drawings.

A plurality of dies may be integrated in a single package, sizes and shapes of the dies may be different, and the plurality of dies may be arranged in a plurality of manners. Therefore, a bounding box of the plurality of dies integrated in the single package are affected by the sizes, the shapes, and arrangements of the plurality of dies.

In some cases, the sizes, the shapes, and the arrangements of the plurality of dies integrated in the single package determine that the bounding box of the plurality of dies may be classified into three types. The three types are separately described below.

### 1. Die top bounding box (Die Top Bounding Box)

The die top bounding box is a boundary formed by peripheral dies in all the dies in the single package. Generally, the boundary is a rectangular boundary.

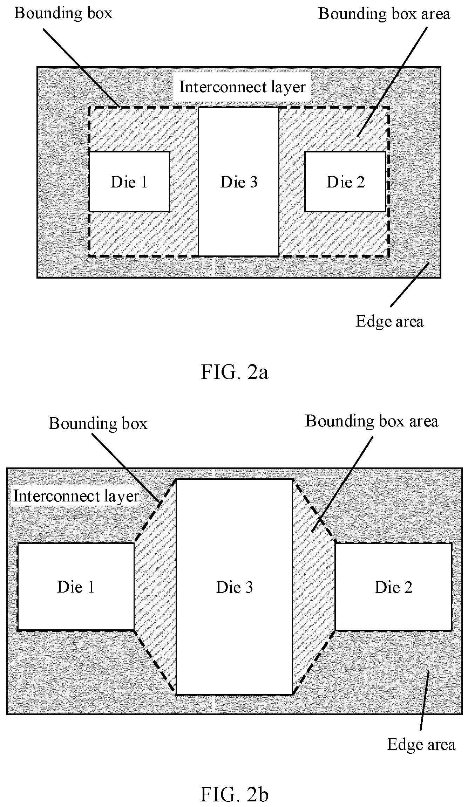

For example, FIG. 2a provides a die top bounding box inside which three dies are located. The three dies are disposed on an interconnect layer. The three dies are a first die (a die 1), a second die (a die 2), and a third die (a die 3) respectively. The first die and the second die have a same size, and the third die has a different size from the first die and the second die. The three dies have a same shape and the shape may be considered as a rectangle. The three dies are arranged by row, the first die is not adjacent to the second die, the third die is located between the first die and the second die, and the third die is separately adjacent to the first die and the second die.

In FIG. 2a, a dashed-line box is the bounding box. Because the dashed-line box is a rectangular boundary formed by a boundary of peripheral dies in the three dies, the bounding box is a die top bounding box. Further, FIG. 2a further provides a bounding box area and an edge area. An area enclosed by the bounding box on the interconnect layer (including an area in which slashes are located and areas covered by the three dies) is the bounding box area, and an area outside the bounding box on the interconnect layer is the edge area.

### 2. Die angle bounding box (Die Angle Bounding Box)

The die angle bounding box is a boundary formed by vertex connecting lines of all dies in a single package.

For example, FIG. 2b provides a die angle bounding box inside which three dies are located. The three dies are located on an interconnect layer. The three dies are a first die (a die 1), a second die (a die 2), and a third die (a die 3) respectively. The first die and the second die have a same size, and the third die has a different size from the first die and the second die. The three dies have a same shape and the shape may be considered as a rectangle. The three dies are arranged by row, the first die is not adjacent to the second die, the third die is located between the first die and the second die, and the third die is separately adjacent to the first die and the second die.

In FIG. 2b, a dashed-line box is the bounding box. Because the dashed-line box is a boundary formed by vertex connecting lines of the three dies, the bounding box is a die angle bounding box. Further, FIG. 2b further provides a bounding box area and an edge area. An area enclosed by the bounding box on the interconnect layer (including an area in which slashes are located and areas covered by the three dies) is the bounding box area, and an area outside the bounding box on the interconnect layer is the edge area.

### 3. Die gap bounding box (Die Gap Bounding Box)

The die gap bounding box is a boundary that covers gap (Gap) areas among all dies in a single package and areas of all the dies, where a gap may be a gap formed between two dies, or may be a gap formed among more than two dies.

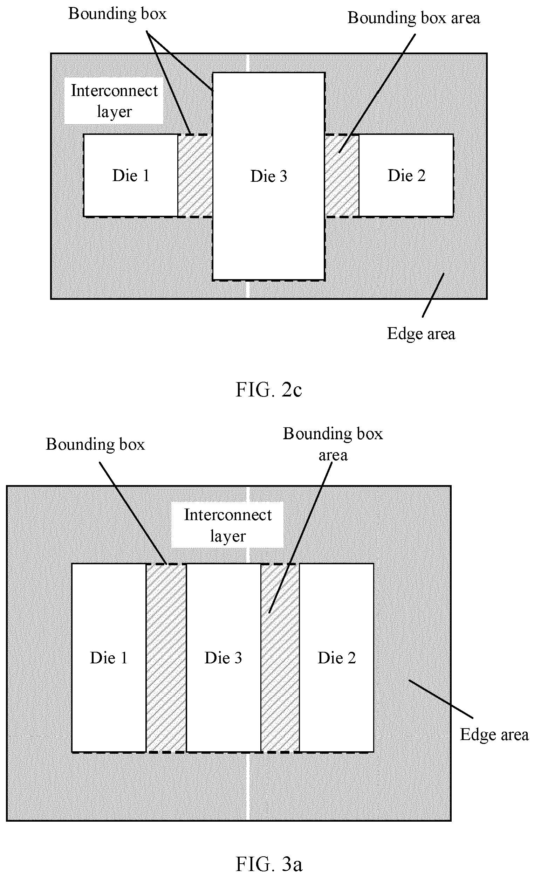

For example, FIG. 2c provides a die gap bounding box inside which three dies are located. The three dies are located on an interconnect layer. The three dies are a first die (die 1), a second die (die 2), and a third die (die 3) respectively. The first die and the second die have a same size, and the third die has a different size from the first die and the second die. The three dies have a same shape and the shape may be considered as a rectangle. The three dies are arranged by row, the first die is not adjacent to the second die, the third die is located between the first die and the second die, and the third die is separately adjacent to the first die and the second die.

In FIG. 2c, a dashed-line box is the bounding box, a part of the dashed-line box is a boundary that covers the areas of the three dies, and the other part of the dashed-line box is a boundary that covers the gap areas among the dies. For example, the other part is a boundary that covers upper and lower boundaries (excluding left and right boundaries) of a gap between the die 1 and the die 3 and upper and lower boundaries (excluding left and right boundaries) of a gap between the die 2 and the die 3. Further, FIG. 2c further provides a bounding box area and an edge area. An area enclosed by the bounding box on the interconnect layer (including an area in which slashes are located and the areas covered by the three dies) is the bounding box area, and an area outside the bounding box on the interconnect layer is the edge area.

For the foregoing description, the following points need to be noted:
1. When the three types of bounding boxes are described above, three dies are used as an example for description. Actually, a plurality of dies may be integrated into a single package, for example, five, seven, or nine dies. A quantity of the plurality of chips integrated into the single package is not limited in this application.
2. When the three types of bounding boxes are described above, the three dies are used as an example for description. In addition, sizes, shapes, and arrangements of the three dies are further described. For example, the first die and the second die have the same size, the third die has the different size from the first die and the second die, the shapes of the three dies are the same, the three dies are arranged by row, and the like. Actually, the sizes, the shapes, and the arrangements of the plurality of dies integrated in the single package may be in various forms. For example, the sizes of the dies are different, the shapes of the dies are different, the dies are arranged by column, or the like. The sizes, the shapes, and the arrangements of the plurality of chips integrated in the single package are not limited in this application.

It can be learned from FIG. 2a, FIG. 2b, and FIG. 2c that, in some cases, the sizes, the shapes, and the arrangements of the plurality of dies integrated in the single package determine that a bounding box of the plurality of dies may be classified into the foregoing three types. However, in some other cases, the sizes, the shapes, and the arrangements of the plurality of dies integrated in the single package determine that there is only one type of bounding box of the plurality of dies, or that bounding boxes obtained through classification based on the foregoing three types essentially belong to a same type. The following further describes this case.

Case 1: The plurality of dies integrated in the single package have a same size and shape, and are arranged according to a particular rule, for example, arranged by row or column. In this case, there is only one type of bounding box of the plurality of dies.

For example, FIG. 3a provides a bounding box inside which three dies are located. The three dies are located on an interconnect layer. The three dies are a first die (a die 1), a second die (a die 2), and a third die (a die 3) respectively. The three dies have the same size and shape, the three dies are arranged by row, the first die is not adjacent to the second die, the third die is located between the first die and the second die, and the third die is separately adjacent to the first die and the second die.

In FIG. 3a, a dashed-line box is the bounding box. If bounding boxes are formed based on the foregoing three types, it is found that the finally presented bounding boxes are the same, which is as shown in FIG. 3a. Further, FIG. 3a further provides a bounding box area and an edge area. An area enclosed by the bounding box on the interconnect layer (including an area in which slashes are located and areas covered by the three dies) is the bounding box area, and an area outside the bounding box on the interconnect layer is the edge area.

Case 2: The plurality of dies integrated in the single package have different sizes and shapes, and are arranged according to a particular rule, for example, arranged by row or column. In this case, there is also only one type of bounding box of the plurality of dies.

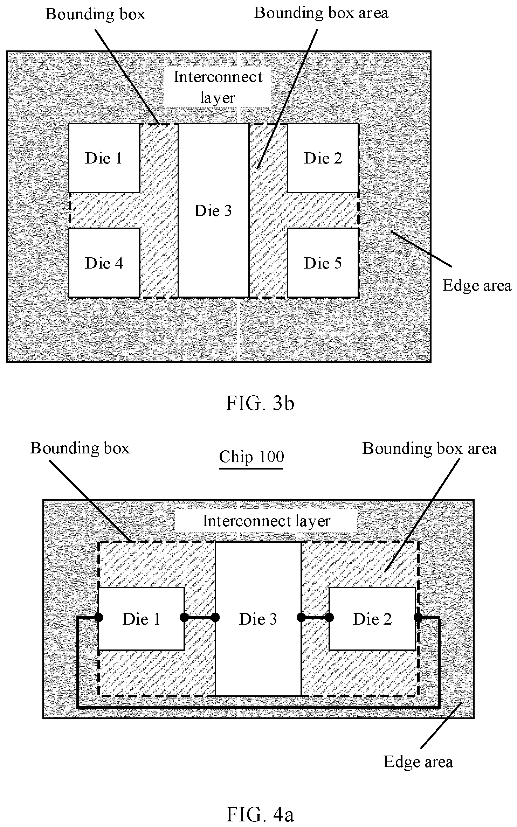

For example, FIG. 3b provides a bounding box inside which five dies are located. The five dies are located on an interconnect layer. The five dies are a first die (a die 1), a second die (a die 2), a third die (a die 3), a fourth die (a die 4), and a fifth die (a die 5) respectively. Sizes and shapes of the first die, the second die, the fourth die, and the fifth die in the five dies are all the same, but the sizes and the shapes (a square) of the four dies are all different from a size and a shape (a rectangle) of the third die. The five dies are arranged in a manner shown in FIG. 3b, the first die is not adjacent to the second die and the fifth die, the second die is not adjacent to the first die and the fourth die, the fourth die is not adjacent to the second die and the fifth die, the fifth die is not adjacent to the first die and the fourth die, and the third die is adjacent to all the other four dies.

In FIG. 3b, a dashed-line box is the bounding box. If bounding boxes are formed based on the foregoing three types, it is found that the finally presented bounding boxes are the same, which is as shown in FIG. 3b. Further, FIG. 3b further provides a bounding box area and an edge area. An area enclosed by the bounding box on the interconnect layer (including an area in which slashes are located and areas covered by the three dies) is the bounding box area, and an area outside the bounding box on the interconnect layer is the edge area.

For the foregoing description, the following points need to be noted:
1. Only two cases are listed above. Actually, there may be a plurality of other cases that result in that there is only one type of bounding box of the plurality of dies in the single package. The plurality of other cases that are not listed are not limited in this application.
2. In the foregoing two listed cases, three dies and five dies are separately used as examples for description. Actually, a plurality of dies may be integrated into a single package, for example, seven or nine dies. A quantity of the plurality of chips integrated into the single package is not limited in this application.

The foregoing mainly describes the bounding box, the bounding box area, and the edge area of the plurality of dies integrated in the single package. The following describes routing of a pair of dies in the plurality of dies in an edge area to implement interconnection.

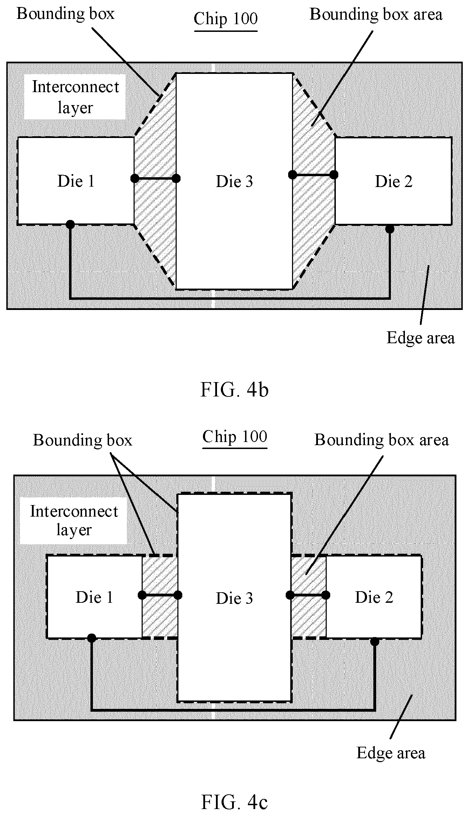

As shown in FIG. 4a, FIG. 4b, and FIG. 4c. an embodiment of this application provides a chip 100. The chip 100 includes an interconnect layer 110 and a plurality of dies disposed on the interconnect layer. The plurality of dies include a first die (a die 1) and a second die (a die 2). The first die and the second die are interconnected through routing in an edge area, where the edge area is an area outside a bounding box on the interconnect layer, and the bounding box is a peripheral boundary of the plurality of dies on the interconnect layer.

Because there is no signal routing in the edge area on the interconnect layer 110, and the edge area is not interfered with by another data signal, the first die and the second die are interconnected through routing in the edge area. In this way, a delay of data signal transmission between the two dies can be reduced, and data transmission efficiency can be improved.

In a first implementation, the first die is adjacent to the second die. To be specific, the adjacent dies are interconnected through routing in the edge area (namely, a non-bounding box area) on the interconnect layer. As described above, the adjacent dies are generally connected through direct routing in the bounding box area. Generally, a delay of transmission caused by direct routing in the bounding box area is low. However, in some specific scenarios, for example, in a scenario in which routing is interfered with by a large quantity of signals, a problem of a high delay of transmission may also exist. In this implementation, the problem of the high delay of transmission caused in these specific scenarios can be resolved. It is considered that scenarios to which this implementation is applied are limited, this application does not provide further description, and no corresponding accompanying drawing is provided for description.

In a second implementation, as shown in FIG. 4a, FIG. 4b, and FIG. 4c, the first die is not adjacent to the second die. In other words, the non-adjacent dies are connected through routing in the edge area (namely, the non-bounding box area) on the interconnect layer. Compared with that non-adjacent dies are interconnected by crossing an intermediate die (in other words, interconnection is implemented through indirect routing), in this implementation, the first die and the second die that are not adjacent are interconnected through routing in the edge area, so that the delay of data signal transmission between the two dies can be reduced.

Further, in the foregoing second implementation, adjacent dies may further exist in the plurality of dies. Because there is no other die between the adjacent dies, the adjacent dies may be interconnected through direct routing in the bounding box area of the plurality of dies on the interconnect layer. As shown in FIG. 4a, FIG. 4b, and FIG. 4c, there is a third die (a die 3) between the first die and the second die that are not adjacent. The third die is adjacent to the first die, and the third die and the first die are interconnected through direct routing in the bounding box area. The third die is adjacent to the second die, and the third die and the second die are interconnected through direct routing in the bounding box area.

The following further describes, with reference to each type of bounding box, a routing manner of the plurality of dies in the chip provided in the second implementation in the foregoing embodiment. It should be noted that, FIG. 2a, FIG. 2b, and FIG. 2c provide the die top bounding box, the die angle bounding box, and the die gap bounding box inside which three dies are located respectively, and FIG. 4a, FIG. 4b, and FIG. 4c are schematic diagrams of routing in FIG. 2a, FIG. 2b, and FIG. 2c in sequence.

### 1. Routing on the die top bounding box

FIG. 4a is a schematic diagram of routing on the die top bounding box provided in FIG. 2a. It can be learned from FIG. 4a that, a difference between FIG. 4a and FIG. 2a is that a routing manner of the three dies in the single package is added. The die 1 is adjacent to the die 3, and the die 1 and the die 3 are interconnected through direct routing in the bounding box area. The die 3 is adjacent to the die 2, and the die 3 and the die 2 are interconnected through direct routing in the bounding box area. The die 1 is not adjacent to the die 2, and the die 1 and the die 2 are interconnected through routing in the edge area.

### 2. Routing on the die angle bounding box

FIG. 4b is a schematic diagram of routing on the die angle bounding box provided in FIG. 2b. It can be learned from FIG. 4b that, a difference between FIG. 4b and FIG. 2b is that a routing manner of the three dies in the single package is added. The die 1 is adjacent to the die 3, and the die 1 and the die 3 are interconnected through direct routing in the bounding box area. The die 3 is adjacent to the die 2, and the die 3 and the die 2 are interconnected through direct routing in the bounding box area. The die 1 is not adjacent to the die 2, and the die 1 and the die 2 are interconnected through routing in the edge area.

### 3. Routing on the die gap bounding box

FIG. 4c is a schematic diagram of routing on the die gap bounding box provided in FIG. 2c. It can be learned from FIG. 4c that, a difference between FIG. 4c and FIG. 2c is that a routing manner of the three dies in the single package is added. The die 1 is adjacent to the die 3, and the die 1 and the die 3 are interconnected through direct routing in the bounding box area. The die 3 is adjacent to the die 2, and the die 3 and the die 2 are interconnected through direct routing in the bounding box area. The die 1 is not adjacent to the die 2, and the die 1 and the die 2 are interconnected through routing in the edge area.

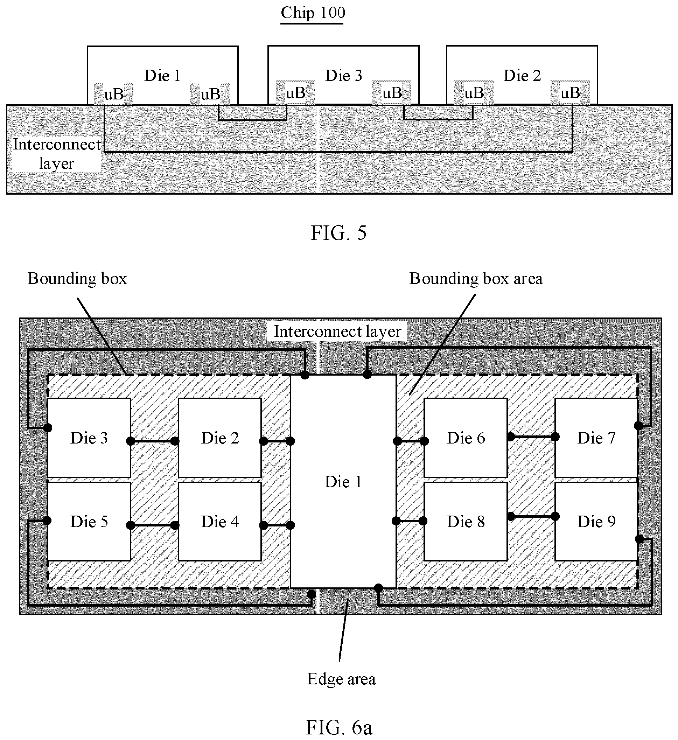

It should be noted that FIG. 4a, FIG. 4b, and FIG. 4c are all top-view diagrams, FIG. 5 provides cross-sectional views corresponding to FIG. 4a, FIG. 4b, and FIG. 4c, and the cross-sectional views corresponding to FIG. 4a, FIG. 4b, and FIG. 4c are the same. Because FIG. 5 is the cross-sectional view, it cannot be seen from FIG. 5 that routing of the die 1 and the die 3 and routing of the die 3 and the die 2 pass through the bounding box area, and routing of the die 1 and the die 2 passes through the edge area. In addition, each die in FIG. 5 includes uBumps (uBump, uB), and the uBumps are configured to implement interconnection for the dies through routing.

FIG. 4a, FIG. 4b, and FIG. 4c are described by using an example of routing of the three dies that are integrated in the single package. To describe that a plurality of dies may be integrated in a single package, the following further describes an example of routing of nine dies that are integrated in a single package.

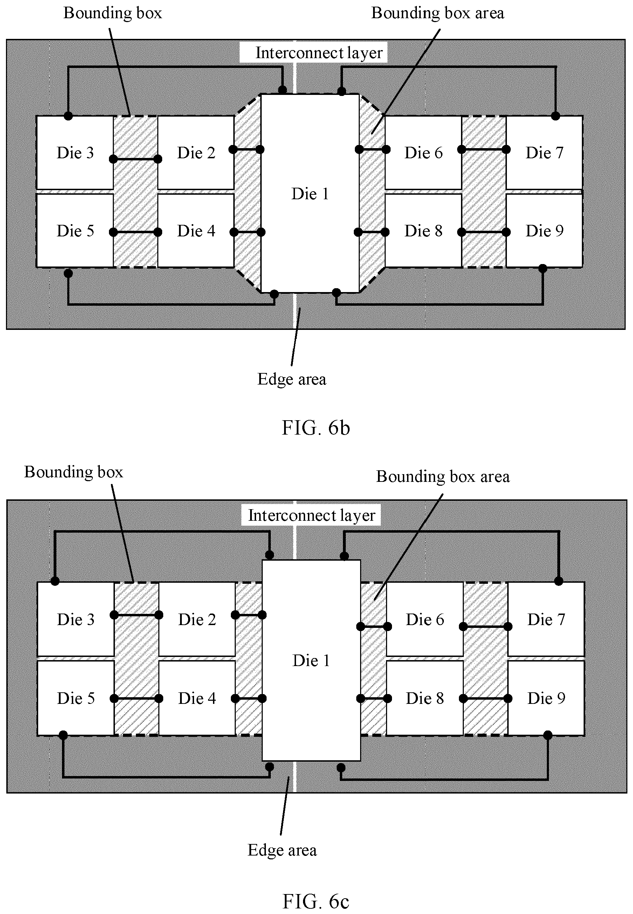

FIG. 6a, FIG. 6b, and FIG. 6c provide a routing manner of nine dies integrated in a single package. FIG. 6a is a schematic diagram of routing of the nine dies based on a die top bounding box, FIG. 6b is a schematic diagram of routing of the nine dies based on a die angle bounding box, and FIG. 6c is a schematic diagram of routing of the nine dies based on a die gap bounding box.

It can be learned from FIG. 6a, FIG. 6b, and FIG. 6c that the nine dies are sequentially a die 1, a die 2, a die 3, a die 4, a die 5, a die 6, a die 7, a die 8, and a die 9. The die 2 is adjacent to the die 1 and the die 3. Therefore, the die 2 is interconnected to the die 1 and the die 3 through routing in a bounding box area. The die 4 is adjacent to the die 1 and the die 5. Therefore, the die 4 is interconnected to the die 1 and the die 5 through routing in the bounding box area. The die 6 is adjacent to the die 1 and the die 7. Therefore, the die 6 is interconnected to the die 1 and the die 7 through routing in the bounding box area. The die 8 is adjacent to the die 1 and the die 9. Therefore, the die 8 is interconnected to the die 1 and the die 9 through routing in the bounding box area. It should be noted that, not any two adjacent dies are interconnected through routing. If there is no requirement for data communication between the two adjacent dies, the two dies do not need to be interconnected through routing. For example, there are a plurality of pairs of adjacent dies (the die 2 and the die 4, the die 7 and the die 9, and the like) in FIG. 6a, FIG. 6b, and FIG. 6c. Because there is no requirement for data communication between the adjacent dies, they are not interconnected through routing in the bounding box area.

Further, it can be learned from FIG. 6a, FIG. 6b, and FIG. 6c that the die 1 is not adjacent to any one of the die 3, the die 5, the die 7, and the die 9. Therefore, the die 1 is interconnected to the die 3, the die 5, the die 7, and the die 9 through routing in an edge area. Similarly, not all two non-adjacent dies are interconnected through routing. If there is no requirement for data communication between the two non-adjacent dies, the two dies do not need to be interconnected through routing. For example, there are a plurality of pairs of non-adjacent dies (the die 3 and the die 7, the die 5 and the die 9, and the like) in FIG. 6a, FIG. 6b, and FIG. 6c. Because there is no requirement for data communication between the non-adjacent dies, they are not interconnected through routing in the edge area.

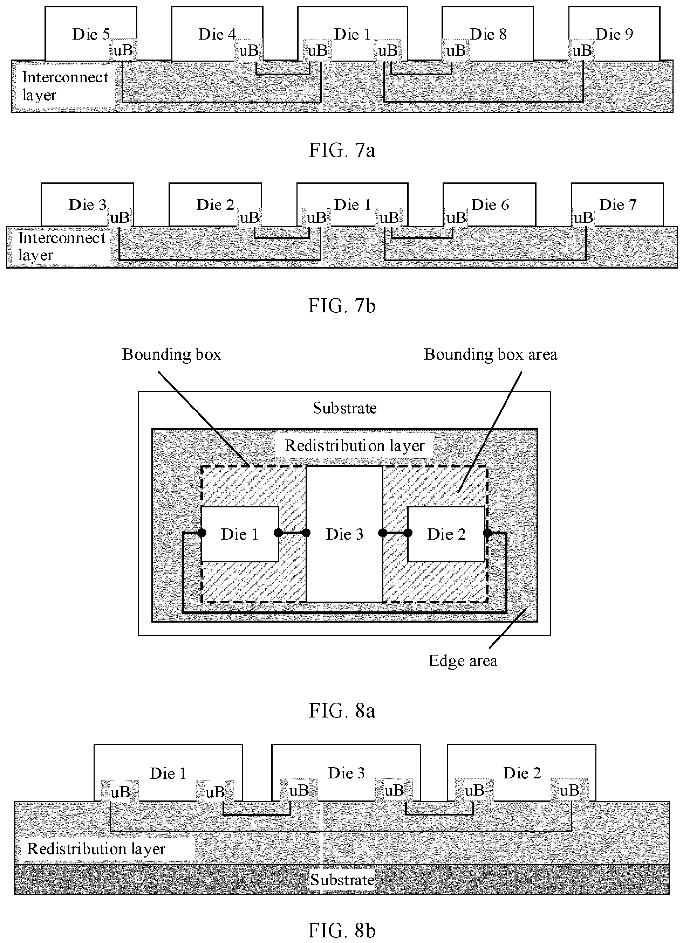

It should be noted that FIG. 6a, FIG. 6b, and FIG. 6c are all top-view diagrams, and FIG. 7a and FIG. 7b provide two cross-sectional views corresponding to FIG. 6a, FIG. 6b, and FIG. 6c. In FIG. 7a, cutting is performed on one side of the die 5, the die 4, the die 1, the die 8, and the die 9. In FIG. 7b, cutting is performed on one side of the die 3, the die 2, the die 1, the die 6, and the die 7. FIG. 4a, FIG. 4b, and FIG. 4c may all correspond to the two cross-sectional views. Similar to FIG. 5, in FIG. 7a and FIG. 7b, it cannot be seen whether routing for the dies passes through a bounding box area or an edge area.

In the 2.5D packaging technology, a packaging technology for the plurality of dies includes fan-out packaging (FOP), CoWoS (Chip-on-Wafer-on-Substrate) packaging, multi-chip module (Multi-Chip Module, MCM) packaging, and other packaging manners. For different packaging manners, the interconnect layer may have different forms. The following further describes the interconnect layer based on the different packaging manners. It should be noted that, the following describes each packaging manner based on routing on a die top bounding box. Actually, the other two types of bounding boxes may also be applied to the three packaging manners. For brevity of description, application of the other two types of bounding boxes to the three packaging manners is not further described in this application.

### 1. FOP packaging

In the FOP packaging, an interconnect layer is an RDL, a substrate is below the RDL, and a plurality of dies are on the RDL.

FIG. 8a provides a schematic diagram of interconnection of three dies in a single package through routing based on an FOP packaging manner and a die top bounding box. A difference between FIG. 8a and FIG. 4a is that the interconnect layer is a redistribution layer and a substrate is below the redistribution layer.

Correspondingly, FIG. 8b provides a cross-sectional view corresponding to FIG. 8a, and a hierarchical relationship among the substrate, the redistribution layer, and the dies can be clearly seen from FIG. 8b.

### 2. CoWoS packaging

In the CoWoS packaging, the interconnect layer is an interposer (interposer), a substrate is below the interposer, and a plurality of dies are on the interposer.

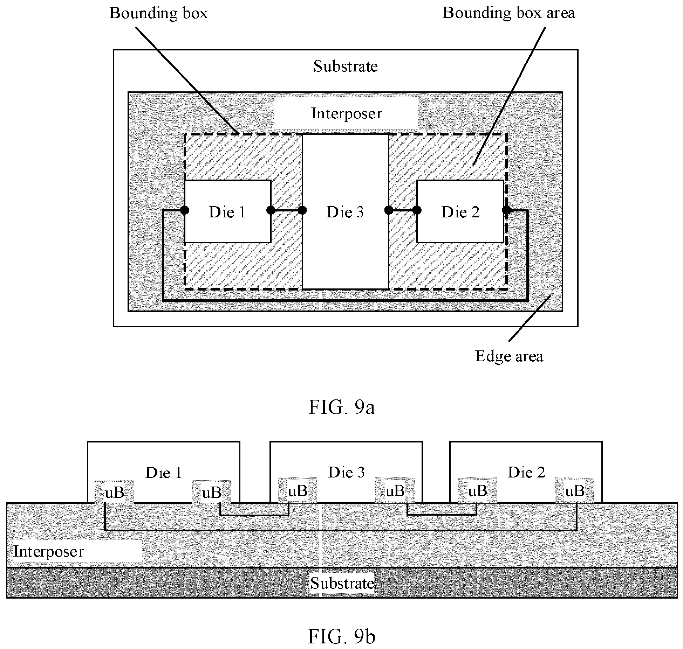

FIG. 9a is used as an example. FIG. 9a provides a schematic diagram of interconnection of three dies in a single package through routing based on a CoWoS packaging manner and a die top bounding box. A difference between FIG. 9a and FIG. 4a is that the interconnect layer is an interposer and a substrate is below the interposer.

Correspondingly, FIG. 9b provides a cross-sectional view corresponding to FIG. 9a, and a hierarchical relationship among the substrate, the interposer, and the dies can be clearly seen from FIG. 9b.

### 3. MCM packaging

In the MCM packaging, the interconnect layer is a substrate, and there are a plurality of dies on the substrate.

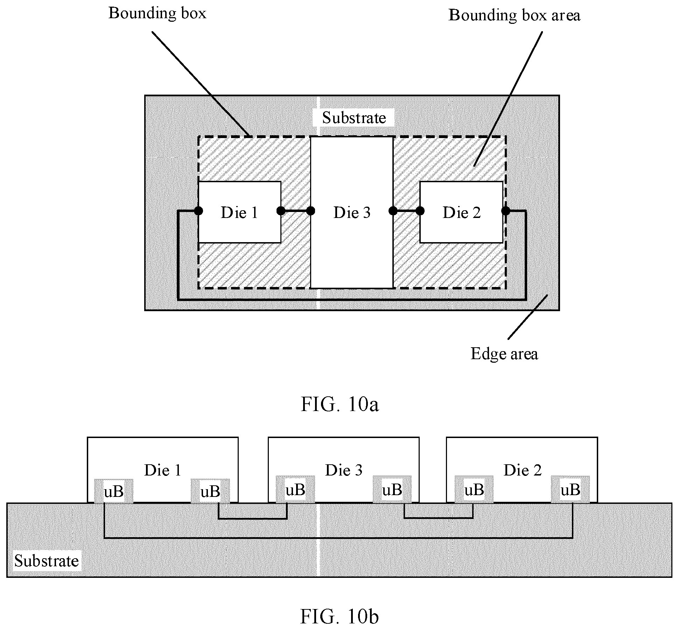

FIG. 10a provides a schematic diagram of interconnection of three dies in a single package through routing based on an MCM packaging manner and a die top bounding box. A difference between FIG. 10a and FIG. 4a is that the interconnect layer is a substrate.

Correspondingly, FIG. 10b provides a cross-sectional view corresponding to FIG. 10a, and a hierarchical relationship among the substrate and the dies can be clearly seen from FIG. 10b.

Based on the foregoing embodiments, this application further provides an integrated chip. The integrated chip includes a first chip and a second chip. The first chip is the chip provided in the foregoing embodiments. The second chip may be the chip provided in the foregoing embodiments or a chip in another form. The first chip and the second chip are packaged together, the first chip may be packaged with the second chip through packaging on packaging (packaging on packaging, POP), fan-out wafer level packaging (fan out wafer level packaging, FOWLP), or another packaging manner. This is not limited in this application.

It should be noted that the "chip" described in this application may be a chip product that has been packaged, or may be a chip product that has not been packaged (or referred to as "half-packaged"), or even has not been packaged. This is not limited in this application.

It should be noted that, although it is pointed out in the foregoing embodiments of this application that interconnection and communication are implemented between non-adjacent dies in a plurality of dies integrated in a single package through routing in an edge area, it is not required that interconnection and communication are implemented on all non-adjacent dies in the plurality of dies through routing in the edge area. Actually, a plurality of pairs of non-adjacent dies may exist in the plurality of dies integrated in the single package. Some of the non-adjacent dies are sensitive to a delay of data signal transmission among them. In other words, the non-adjacent dies require the delay of data signal transmission to be low. Therefore, interconnection and communication among the non-adjacent dies are implemented through routing in the edge area. Other adjacent dies are not sensitive to a delay of data transmission among the dies. Therefore, interconnection and communication may be implemented among these non-adjacent dies by crossing an intermediate die. Although a delay of transmission is large when the interconnection and communication are implemented by crossing the intermediate die, routing is performed in the bounding box area on the interconnect layer, the bounding box area is larger than the edge area, more and longer routing may be performed, and a larger communication bandwidth can be supported. On the contrary, because the bounding box area is generally small and narrow, routing is limited, and a communication bandwidth supported by routing in the bounding box area on the interconnect layer is limited.

## Claims

1. A chip (100), comprising:
an interconnect layer; and
a plurality of dies disposed on the interconnect layer, wherein the plurality of dies comprise a first die and a second die, the first die and the second die are interconnected through routing in an edge area, the edge area is an area outside a bounding box on the interconnect layer, and the bounding box is a peripheral boundary of the plurality of dies on the interconnect layer,
wherein the first die is not adjacent to the second die,
wherein the plurality of dies further comprise a third die, the first die is adjacent to the third die, the first die and the third die are interconnected through routing in a bounding box area on the interconnect layer, and the bounding box area is an area enclosed by the bounding box on the interconnect layer, and
wherein the second die is adjacent to the third die, and the second die and the third die are interconnected through routing in the bounding box area on the interconnect layer.

2. The chip (100) according to claim 1, wherein the bounding box is a die top bounding box, and the die top bounding box indicates a boundary formed by peripheral dies in the plurality of dies.

3. The chip (100) according to any one of claims 1 or 2, wherein the bounding box is a die angle bounding box, and the die angle bounding box indicates a boundary formed by vertex connecting lines of the plurality of dies.

4. The chip (100) according to any one of claims 1 to 3, wherein the bounding box is a die gap bounding box, and the die gap bounding box indicates a boundary that covers gap areas among the plurality of dies and areas of the plurality of dies.

5. The chip (100) according to any one of claims 1 to 4, wherein the bounding box is determined based on sizes, shapes, and arrangements of the plurality of dies.

6. The chip (100) according to any one of claims 1 to 5, wherein a packaging manner of the chip (100) is fan-out packaging, and the interconnect layer is a redistribution layer.

7. The chip (100) according to any one of claims 1 to 5, wherein a packaging manner of the chip (100) is CoWoS packaging, and the interconnect layer is an interposer.

8. The chip (100) according to any one of claims 1 to 5, wherein a packaging manner of the chip (100) is a multi-chip module packaging, and the interconnect layer is a substrate.

9. The chip (100) according to any one of claims 1 to 8, wherein each of the plurality of dies comprises uBumps, and the plurality of dies are interconnected through routing by using the uBumps.

10. An integrated chip (100), comprising a first chip and a second chip, wherein the first chip is the chip according to any one of claims 1 to 9, and the first chip and the second chip are packaged together.

## Patentansprüche

1. Chip (100), der umfasst:
eine Zwischenverbindungsschicht und
eine Vielzahl von Dies, die auf der Zwischenverbindungsschicht angeordnet sind, wobei die Vielzahl von Dies ein erstes Die und ein zweites Die umfassen, das erste Die und das zweite Die durch Verdrahten in einem Randbereich miteinander verbunden sind, der Randbereich ein Bereich außerhalb eines Begrenzungsrahmens auf der Zwischenverbindungsschicht ist und der Begrenzungsrahmen eine periphere Grenze der Vielzahl von Dies auf der Zwischenverbindungsschicht ist,
wobei das erste Die nicht an das zweite Die angrenzt,
wobei die Vielzahl von Dies ferner ein drittes Die umfassen, das erste Die an das dritte Die angrenzt, das erste Die und das dritte Die durch Verdrahten in einem Begrenzungsrahmenbereich auf der Zwischenverbindungsschicht miteinander verbunden sind und der Begrenzungsrahmenbereich ein Bereich ist, der durch den Begrenzungsrahmen auf der Zwischenverbindungsschicht umschlossen ist, und
wobei das zweite Die an das dritte Die angrenzt und das zweite Die und das dritte Die durch Verdrahten im Begrenzungsrahmenbereich auf der Zwischenverbindungsschicht miteinander verbunden sind.

2. Chip (100) nach Anspruch 1, wobei der Begrenzungsrahmen ein Die-Oberseiten-Begrenzungsrahmen ist und der Die-Oberseiten-Begrenzungsrahmen eine Grenze angibt, die durch periphere Dies in der Vielzahl von Dies gebildet wird.

3. Chip (100) nach einem der Ansprüche 1 oder 2, wobei der Begrenzungsrahmen ein Die-Winkel-Begrenzungsrahmen ist und der Die-Winkel-Begrenzungsrahmen eine Grenze angibt, die durch Eckpunktverbindungslinien der Vielzahl von Dies gebildet wird.

4. Chip (100) nach einem der Ansprüche 1 bis 3, wobei der Begrenzungsrahmen ein Die-Spalt-Begrenzungsrahmen ist und der Die-Spalt-Begrenzungsrahmen eine Grenze angibt, die Spaltbereiche unter der Vielzahl von Dies und Bereichen der Vielzahl von Dies abdeckt.

5. Chip (100) nach einem der Ansprüche 1 bis 4, wobei der Begrenzungsrahmen basierend auf Größen, Formen und Gestaltungen der Vielzahl von Dies bestimmt wird.

6. Chip (100) nach einem der Ansprüche 1 bis 5, wobei eine "Packaging"-Weise des Chips (100) ein "Fan-Out-Packaging" ist und die Zwischenverbindungsschicht eine Umverteilungsschicht ist.

7. Chip (100) nach einem der Ansprüche 1 bis 5, wobei eine "Packaging"-Weise des Chips (100) ein "CoWoS-Packaging" ist und die Zwischenverbindungsschicht ein Interposer ist.

8. Chip (100) nach einem der Ansprüche 1 bis 5, wobei eine "Packaging"-Weise des Chips (100) ein "Multi-Chip-Modul-Packaging" ist und die Zwischenverbindungsschicht ein Substrat ist.

9. Chip (100) nach einem der Ansprüche 1 bis 8, wobei jedes der Vielzahl von Dies "uBumps" umfasst und die Vielzahl von Dies durch Verdrahten durch Verwenden der "uBumps" miteinander verbunden sind.

10. Integrierter Chip (100), der einen ersten Chip und einen zweiten Chip umfasst, wobei der erste Chip der Chip nach einem der Ansprüche 1 bis 9 ist und der erste Chip und der zweite Chip zusammen gehäust sind.

## Revendications

1. Plaquette (100), comprenant :
une couche d'interconnexion ; et
une pluralité de puces disposées sur la couche d'interconnexion, la pluralité de puces comprenant une première puce et une deuxième puce, la première puce et la deuxième puce étant interconnectées par un routage dans une région de bord, la région de bord étant une région située à l'extérieur d'une zone de délimitation située sur la couche d'interconnexion, et la zone de délimitation étant une frontière périphérique de la pluralité de puces disposées sur la couche d'interconnexion,
dans laquelle la première puce n'est pas adjacente à la deuxième puce,
dans laquelle la pluralité de puces comprend également une troisième puce, la première puce est adjacente à la troisième puce, la première puce et la troisième puce sont interconnectées par un routage dans une région de zone de délimitation de la couche d'interconnexion, et la région de zone de délimitation est une région entourée par la zone de délimitation sur la couche d'interconnexion, et
dans laquelle la deuxième puce est adjacente à la troisième puce, et la deuxième puce et la troisième puce sont interconnectées par un routage dans la région de zone de délimitation sur la couche d'interconnexion.

2. Plaquette (100) selon la revendication 1, dans laquelle la zone de délimitation est une zone de délimitation de sommet de puce, et la zone de délimitation de sommet de puce indique une frontière formée par les puces périphériques de la pluralité de puces.

3. Plaquette (100) selon l'une quelconque des revendications 1 et 2, dans laquelle la zone de délimitation est une zone de délimitation d'angle de puce, et la zone de délimitation d'angle de puce indique une frontière formée par des lignes de raccordement de vertex de la pluralité de puces.

4. Plaquette (100) selon l'une quelconque des revendications 1 à 3, dans laquelle la zone de délimitation est une zone de délimitation d'écartement de puces, et la zone de délimitation d'écartement de puces indique une frontière qui couvre des régions d'écartement faisant partie de la pluralité de puces et des régions de la pluralité de puces.

5. Plaquette (100) selon l'une quelconque des revendications 1 à 4, dans laquelle la zone de délimitation est déterminée sur la base des tailles, des formes et des agencements de la pluralité de puces.

6. Plaquette (100) selon l'une quelconque des revendications 1 à 5, dans laquelle une méthode de conditionnement de la plaquette (100) est un conditionnement avec répartition, et la couche d'interconnexion est une couche de redistribution.

7. Plaquette (100) selon l'une quelconque des revendications 1 à 5, dans laquelle une méthode de conditionnement de la plaquette (100) est un conditionnement CoWoS, et la couche d'interconnexion est un interposeur.

8. Plaquette (100) selon l'une quelconque des revendications 1 à 5, dans laquelle une méthode de conditionnement de la plaquette (100) est un conditionnement en module multi-plaquette, et la couche d'interconnexion est un substrat.

9. Plaquette (100) selon l'une quelconque des revendications 1 à 8, dans laquelle chaque puce de la pluralité de puces comprend des uBumps, et les puces de la pluralité de puces sont interconnectées par un routage au moyen des uBumps.

10. Plaquette intégrée (100), comprenant une première plaquette et une deuxième plaquette, la première plaquette étant la plaquette selon l'une quelconque des revendications 1 à 9, et la première plaquette et la deuxième plaquette étant réunies sous un même conditionnement.
